# EUROPEAN PATENT APPLICATION

(11) **EP 2 955 485 A1**
(43) Date of publication of application: **16.12.2015**
(21) Application number: 14290173.5
(22) Date of filing: 13.06.2014
(51) Int. Cl.: G01D 4/00

(54) **Method for collecting load profile data**

(71) Applicant: Alcatel Lucent, 92100 Boulogne-Billancourt (FR)
(72) Inventor: Ozhan, Oguz, 34776 Istanbul (TR)
(74) Representative: Louis Pöhlau Lohrentz

(57) **Abstract**

The present invention concerns method for collecting, by a meter-reader 1, data of a load profile from a meter 2, the method comprising receiving 3, by the meter-reader 1, a non brand-specific load profile query, processing, by the meter-reader 1, the non brand-specific load profile query according to a brand of the meter 2 into a brand-specific load profile query and retrieving 5, by the meter-reader 1, data of a load profile from the meter 2 based on said brand-specific load profile query. The present invention concerns further the meter-reader 1 used for the method for collecting a load profile from a meter 2 and a processing unit 7.

## Description

### Background

Meters are used to measure values of consumption of e.g. electricity, water or gas. The measurements taken by the meters which give a load profile of the consumption must then read by meter-readers to transmit the measured values to a billing centre. For example, one meter might be installed at a house of which the electricity consumption is measured. One further meter might be installed at the house to measure the water consumed at that house. For commonly used meters, e.g., electricity meters, almost every brand, this is the manufacturer of the meter, has its own load profile query code. The query code is the format which is used by the meter-reader for retrieving the data measured by the meter, this means for the communication between the meter-reader and the meter. As every brand of meters has its own query code, for the meter-readers, brand-specific inputs to request load profiles are necessary. The user of the meter-reader must therefore use the codes predetermined by the manufactures of the meter.

### Summary of the invention

It is an objective of the invention to provide an at least improved solution for retrieving measurement data from a meter by a meter-reader.

The objective of the invention is achieved by a method for collecting, by a meter-reader, data of a load profile from a meter. The method comprises receiving, by the meter-reader, a non brand-specific load profile query, processing, by the meter-reader, the non brand-specific load profile query according to a brand of the meter into a brand-specific load profile query; and retrieving, by the meter-reader, data of a load profile from the meter based on said brand-specific load profile query.

The objective of the invention is further achieved by a meter-reader for collecting data of a load profile from a meter. The meter-reader is configured for receiving a non brand-specific load profile query, processing the non brand-specific load profile query according to a brand of the meter and retrieving data of a load profile from the meter based on said brand-specific load profile query,

The objective of the invention is further achieved by a processing unit used for collecting data of a load profile from a meter, the processing unit adapted for receiving a non brand-specific load profile query, processing the non brand-specific load profile query according to a brand of the meter and retrieving data of a load profile from the meter based on said brand specific load profile query.

The objective of the invention is further achieved by a software product adapted to execute the method according to claims 1 to 12, when executed on a computer.

Further features and advantages are implemented and achieved by preferred embodiments of the invention. The embodiments are not to be understood as being exclusive, but as being combinable, such that features of embodiments might be combined to form further preferred embodiments.

The features of the present invention and thus the embodiments of the present invention might be implemented by hardware, software and/or combination thereof.

In a preferred embodiment, the meter-reader receives a non brand-specific load profile query. A non brand-specific load profile query is a load profile query using or having a format (or code) independent of the brand(s) of the meter(s). In particular, the meter-reader receives a non brand-specific load profile query, means that the meter-reader receives an input of a load profile request using a format independent from the brand of the meter, this is the meter-reader receives an load profile query in a format which might be any format, in particular a single, unified, common format which is not predetermined by the brand(s) of the meter(s), respecitively, from which measurements are to be read, but which is a common format used for input the load profile query into the meter-reader. Thus, preferably, the input format is predefined by the meter-reader or the user of the meter-reader, but not predefined by the brand of the meter(s).

In a preferred embodiment, for the meter-reader receiving a non brand-specific load profile query a unified request format is used. In a preferred embodiment, for the meter-reader receiving a non brand-specific load profile query a unified request format is used at an interface on a higher level of an automatic meter reading system. The meter-reader is implemented as part of an automatic meter reading system in which by the meter-reader automatically, in particular in regular predetermined time intervals, e.g. every day, every month, every year, data on a load profile measured by a meter are read. The automatic meter reading system might be implemented hierarchically as a software program - or stack of software programs - comprising different levels, e.g. according to the OSI (OSI = Open Systems Interconnection Model) reference model. The automatic meter reading system might be implemented by hardware on which such software is executed. On a higher level of the software program stack, a format is used for the input of a load profile query, wherein the format is independent from the brand of the meter, from which the load profile data are then read by the meter-reader. Preferably, the input is given by a user of the meter-reader at an interface to the meter-reader, where the user inputs a query of a load profile in a format independent from the brand of the meter, from which then by the meter-reader according to the user's query the meter is asked for providing data of a load profile measured by the meter. The format which is independent from the brand of the meter might be termed, a unified format or a common format, because there is only one single, unified or common, format necessary to input the load profile query into the meter-reader. The meter-reader will then, as described later in detail, transform the query request of the user, which is input in the unified, this is non brand-specific format, into a format according to the code or protocol used by the meter, because technically the meter-reader must still use the code which is determined by the meter, this is the brand-specific code, for retrieving load profile data from the meter. Thus, the meter-reader makes a brand-specific load profile query to the meter. The brand-specific load profile query is a load profile query having or using the format (or code) predefined by the meter, namely by the meter from which the meter-reader retrieves load profile data.

Preferably, processing the non brand-specific load profile query comprises transforming the non brand-specific load profile query into a brand-specific load profile query. Thus, when processed, the load profile query is transformed out of the non brand-specific load profile query, this means from a unified, non brand-specific format or code, into in the brand-specific load profile query, thus into the brand-specific format or code according to the brand of the meter with which the meter-reader establishes a communication for retrieving load profile data.

In a preferred embodiment, the meter-reader processes the non brand-specific load profile query. Before, the meter-reader has got the load query from the user who uses the meter-reader to read and get load profile data from the meter. The meter-reader got the query of the user in a format which is not brand-specific. The user uses only a single common format for his query request independent of the brand of the meter. Accordingly, the meter-reader processes the non brand-specific load profile query according to a brand of the meter to transform the non brand-specific query in a query having a query code which is brand-specific, this means in a query code which is determined by the brand of the meter and which is therefore determined by the protocol used by the meter for communication, e.g. data transmittal, with the meter-reader. Thus, the meter-reader determines the brand-specific code according to the brand of the meter. After the meter-reader has determined the brand-specific query code of the meter from which the meter-reader wants to retrieve load profile data, the meter-reader asks the meter for a load profile by using the brand-specific code.

In a preferred embodiment, for determining the brand of the meter the meter-reader sends a trigger signal to the meter and receives from the meter a signal which is carrying information on the brand of the meter. In a preferred embodiment, the meter-reader sends a code request signal to the meter and receives from the meter information on the brand-specific code used by the meter. In a preferred embodiment, the meter-reader determines first the brand of the meter and second the brand specific code used by the meter from the brand of the meter. Alternatively, the meter-reader determines the brand specific code used by the meter without determining explicitly the name of the brand of the meter. In a preferred embodiment, the brand-specific code comprises at least one of an ASCII code or a binary code.

In a preferred embodiment, the meter-reader comprises a memory in which information on the codes, protocols and formats used by different brands of meters. For example, the memory comprises information that a particular brand of meter uses a particular protocol, a particular format and a particular query code. It is noted, that preferably, the particular protocol predefines that particular format and that particular query code.

In preferred embodiments, the meter-reader might access the memory of the meter-reader to retrieve information on a particular protocol, format or code used by a meter based on information on the brand of the meter.

In a preferred embodiment, a meter might use more than one protocol, format or code. Thus, according to the brand of the meter, a particular protocol, format or code used for communication between the meter-reader and the meter must be determined by the meter-reader for communication with the meter, in particular load data retrieval from the meter.

In preferred embodiments, apart of the brand of a meter, the type of the meter might predetermine a particular protocol, format or code used by the meter for communication with the meter-reader.

In a preferred embodiment, the meter-reader determines the brand-specific code according to the brand of the meter by determining the brand of the meter, determining a brand-specific protocol used by the meter and determining the brand-specific code of the meter. The meter-reader might determine the brand of the meter by sending an information request about the brand of the meter to the meter and receiving an information response indicating the brand of the meter from the meter. Alternatively, the meter-reader might read out an indication of the meter, such as a name, number or numerical value, indicating the brand of the meter. Then, after the meter-reader knows the brand (and, preferably, type) of the meter, the meter-reader determines the protocol used by the meter, in particular by means of the above described memory of the meter-reader comprising information about protocols, formats and codes used by meters determined by the brand (and, preferably, types) of the meters. The protocol used by the meter for providing load profile data to the meter-reader might be in particular a protocol using the ASCII code (ASCII = American Standard Code for Information Interchange). Alternatively or in addition, the meter might use a protocol using a binary, e.g. hexadecimal, code for communicating load profile data to the meter-reader. Based on information on the protocol used by the meter, the meter-reader is able to determine the code used by the meter for communication about load profile data query and data transmission with the meter-reader. As, preferably, the protocol used by the meter and the code used by the meter are technically interdependent, the step of determining, by the meter-reader, the protocol used by the meter and the code used by the meter might be implemented in each order or in combination. Preferably, the meter-reader might determine the code used by the meter contemporaneously or before determining the protocol used by the meter, or even without explicitly determining the protocol used by the meter, as in the end the meter-reader is rather interested in the technical code used by the meter than in the name of the protocol used by the meter. In preferred embodiments, the meter might use one protocol, which however, uses both a ASCII code and a binary code. In this case, the meter-reader determines primarily and finally the code used by the meter, because only by knowing the name of the protocol, in this case, the meter-reader is not sure about the code used by the meter, so that the meter-reader determines finally the code of the meter for communication. The meter-reader might determine the code of the meter by sending a plurality of queries, for example implemented as test queries, to the meter in different codes and waiting for a response of the meter. As soon as the meter-reader gets a response from the meter, the meter-reader can determine the code in which the response is sent and thus knows the code used by the meter. Based on the brand-specific code used by the meter, the meter-reader can then retrieve load profile data from the meter.

In a preferred embodiment, the meter-reader determines the brand of the meter from an information given by the user of the meter-reader. The user of the meter-reader determines the brand (and/or type) of the meter and inputs the information about the brand (and/or type) of the meter into the meter-reader. This means after determining the brand (and/or type) of the meter by the user of the meter-reader, the user of the meter-reader provides the information on the brand (and/or type) of the meter as input into the meter-reader. The user of the meter-reader might simply look at the meter, where the brand (and/or type) of the meter is indicated, e.g., by the name of the manufacturer (and/or type) of the meter. The user of the meter-reader might also ask the owner of the meter or the owner of the location where the meter is installed for the brand (and/or type) of the meter. In this case, the user is still deprived of the burden to determine the code or protocol used by the meter. The user has only to provide information about the brand (and/or type) of the meter to the meter-reader. Preferably, the meter-reader comprises a memory in which information about protocols, formats and codes used by one or more meters according to the brands (and/or types) of the meters is stored. The meter-reader, preferably, based on the above described memory of the meter-reader, determines information about protocol, code and format used by the meter based on the information about brand (and/or type) of the meter.

In a preferred embodiment, the meter-reader after determining the code of the meter which the meter uses for communication with the meter-reader, the meter-reader puts the query request of the user which is in a non brand-specific format, in particular non brand-specific code format, into the format, in particular code format, according to the brand of the meter from which the meter-reader then retrieves data on a load profile. This is, the meter-reader processes the non brand-specific load profile query into a brand-specific load profile query by transforming the unified format of the load query which the meter-reader received from a user into the format according to the brand specific code used by the meter from which the meter-reader (then) retrieves load profile data. In other words, the meter-reader puts or transforms the non brand-specific load query of the user into the brand-specific load query by using the brand-specific code according to the brand of the meter. Thus, processing the non brand-specific load query by the meter-reader comprises that the meter-reader transforms the load query from the unified/non brand-specific format into the brand-specific load query using the brand-specific code according to the brand of the meter.

In a preferred embodiment, the meter-reader retrieves data of a load profile from the meter, this is data based on measurements taken by the meter from which a load profile is to be derived. The load profile might be processed by the meter or by the meter-reader based on the data retrieved by the meter-reader from the meter.

In a preferred embodiment, the meter-reader retrieves data of a load profile based on the processed load profile query. The meter-reader has received the load profile query in a non brand-specific query, this means in a common unified format independent from the brand of the meter, has transformed the non brand-specific query in a brand-specific query according to the code used by the meter and has send the brand-specific code to the meter.

In a preferred embodiment, the meter-reader receives from a meter data which can be put into a non exclusive number of categories, this means the data might belong to one or more of one of the following categories: the data might comprise one or more of the groups comprising values read by the meter-reader regularly, values read by the meter-reader at a beginning of a measurement period, values read by the meter-reader at and end of a measurement period, values determining an electrical load, in particular determining an electrical consumption, in particular measured by the meter in kW/h, values determining a consumption of water, values determining a consumption of gas, data indicating relative values by indicating a difference to previously determined data, data indicating absolute values by indicating a total load and/or a total consumption, data stored in a memory of the meter. For instance, the meter-reader might retrieve data about an electrical load - measured by the meter - regularly every month at the beginning of a measurement period and at the end of a measurement period for determining difference values between the respectively measured data, wherein the data have been stored in a memory of the meter and are thus retrieved by the meter-reader from the memory of the meter, in particular by reading by the meter-reader the memory of the meter for the data stored therein, or by sending by the meter the data stored in the memory of the meter to the meter-reader. In preferred embodiment, the meter-reader comprises a memory where the meter-reader stores data retrieved from the meter.

In a preferred embodiment, the data read by the meter-reader, are further processed, for example transmitted to a billing centre for billing purposes. For example, the owner of a house where the meter measures the electrical consumption, is billed for the electricity consumed.

In preferred embodiments, the one or more meters are installed in one or more houses and/or or further locations for measuring data of consumption in the one or more houses and/or further locations.

In preferred embodiments, the meter-reader is installed in adjacency to the one or more meters in the house of the consumer (e.g. of electricity) and the data retrieved by the meter-reader or by the user of the meter-reader are transferred by means of wired or wireless data transmission to the automatic meter reading system, which might be installed at a metering company, preferably connected with a billing station.

In preferred embodiments, the meter-reader is installed far away from the meter. For example, while the one or more meters are installed in one or more houses of consumers of energy, the meter-reader is installed at a metering company (which is preferably connected with the billing station), preferably implemented in connection or integrated in the automatic meter reading system located in the metering company (which is preferably connected with the billing station), and the data are transferred from the meter to the meter-reader via wired or wireless data transmission. In this case, the user of the meter-reader is located at the metering company (which is preferably connected with the billing station).

In preferred embodiments, the data transfer between any of: the meter, the meter-reader, the automatic meter reading system, the metering company and the billing station might be implemented wirelessly (for example radio frequency (RF) transmission or infrared communication, e.g. Zigbee, Bluetooth, WiFi, or any mobile communication technology) or wired (by cable), for example via the Internet (wireless and/or wireline).

In preferred embodiments, one or more of: the meter, the meter-reader, the automatic meter reading system, the metering company and the billing station might be implemented as separate devices or as combined or integrated devices.

### Detailed description

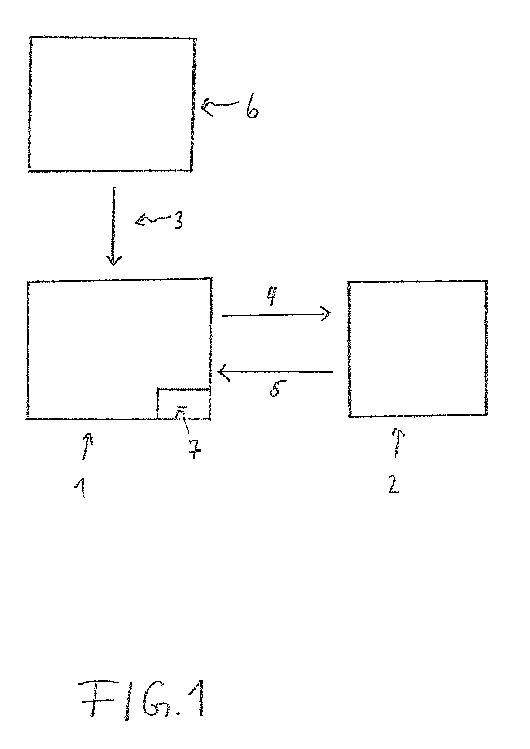

The present invention will be now described in more detail, wherein
FIG. 1 depicts a schematic diagram of an embodiment of a method for collecting load profile data.

Such as the preferred embodiments described in the general part above, the following exemplary embodiments are for illustrative reasons only, whereas the scope of the invention is defined by the claims.

Figure 1 depicts an overview of devices and steps used within an exemplary embodiment of a method for collecting load profile data. A meter-reader 1 is used to collect data of a load profile from a meter 2. The meter-reader 1 receives 3 a non brand-specific load profile query. The non brand-specific load profile query is received by the meter-reader 1 via an interface between the meter-reader 1 and an automatic meter reading system 6, in particular one higher level of the levels of an automatic meter reading system 6. The meter-reader 1 might be combined with the automatic meter reading system 6 or might be implemented as a separate device. The automatic meter reading system 6 might be implemented as a computer executing software programs comprising levels according to the OSI levels. The load profile query comes from a user who wants to retrieve load profile information from the meter 2.

In preferred embodiments, the meter-reader 1 is installed in adjacency to the one or more meters 2 in the house of the consumer (e.g. of electricity, water, gas), where the respective meter(s) 2 is (are) installed, and the data retrieved by the meter-reader 1 or in other words by the user of the meter-reader 1 (from the meter(s) 2) are transferred by means of wired or wireless data transmission to an automatic meter reading system 6, which might be installed at a metering company.

In preferred embodiments, the user of the meter-reader 1 is located far away from the meter 2. The meter 2 is located at the house of the consumer, where e.g. electricity is measured, but the meter-reader 1 or in other words the user of the meter-reader 1 is at a remote location thereto.

In preferred embodiments, the (remote) meter-reader 1 might read data from a plurality of meters 2 installed at a respective plurality of houses, wherein in one house one or more meters 2 might be installed (for example for electricity, water and gas, respectively).

In preferred embodiments, the meter-reader 1 is installed far away from the meter 2. For example, while the one or more meters 2 are installed in one or more houses of consumers of energy, the meter-reader 1 and thus the user of the meter-reader 1 are located for away, e.g, at a metering company. The meter-reader 1 is preferably implemented in connection with or integrated in an automatic meter reading system 6, located e.g. in the metering company, and the data are transferred from the meter 2 to the meter-reader 1 via wired or wireless data transmission.

In preferred embodiments, in case the meter-reader 1 is installed at the house of the consumer of e.g. electricity where the meter 2 is installed, the user of the meter-reader 1 and the consumer of electricity which is measured by the meter 2 might be the same person.

In preferred embodiments, in case the meter-reader 1 is installed far away from the house of the consumer where the meter 2 is installed, the user of the meter-reader 1 is usually not the same person as the consumer. While the consumer might be the owner of the house where the meter 2 is installed, the user of the meter-reader 1 might be a service man of a metering company, where the remote meter-reader 1 is installed (for example connected wirelessly or wired with the meter 2 at the house of the consumer).

In a preferred embodiment, the user of the meter-reader 1, e.g. a service man of a metering company, comes to the house of the consumer, where the meter 2 is installed, and uses a transportable meter-reader 1 for retrieving load profile data from the meter 2 by placing the meter-reader 1 in adjacency to the meter 2 and implementing a wired (e.g. cable) or wireless (e.g. Bluetooth, Zigbee or any mobile communication technology) connection between the meter-reader 1 and the meter 2.

In the exemplary embodiment, the user uses the automatic meter reading system 6 and puts a query in a format which is independent from the brand of the meter 2 into the automatic meter reading system 6. Thus the user does not need to know the brand of the meter, because the user makes this query in a unified format common for all kinds or brands of meters. This is, because according to the method of the invention, the meter-reader 1 will bring the query of the user into the brand-specific format in accordance with the brand of the meter 2 from which the load profile data shall be retrieved.

The brand-specific code depends on the brand of the meter 2 and on the protocol that the meter 2 uses.

In particular, there are two separate protocols. One is ASCII mode (IEC62056-21) and the other is binary (DLMS/Cosem). In particular, one can be used at a time. Some meter models have the ability to use both of them but only one for a session. There is no mixing of protocols. If it is starts with ASCII, it completes with ASCII. If it starts with binary, it completes with binary.

For example, in Turkey, there are ASCII mode communicating brand examples as Kohler, Makel, Luna, Elektromed, Viko, Kaan, Elster and binary mode communicating brand examples as Actaris (Schlumberger) and Landis/Gyr.

According to the protocol, a particular query code is used. Examples of query codes are P1, P.01, 128.12, 96.A.08 and M.01. These query codes are all ASCII, in detail P1(Luna), P.01 (Makel and Elster), 128.12(Kohler), 96.A.08(Viko), M.01 (Elektromed).

For binary codes used by the meter, the codes are defined as a data structure on the meter.

In the present example, the meter-reader 1 can also be regarded and named as the executable for the query to the meter 2. This means, that this is the query side of meter-reader 1 faced to the meters, for example meter 2.

There is also an input side for the meter-reader 1, for example the interface of the automatic meter reading system 6.

In conventional systems the user must know the code of the meter 2 for putting a query request to the meter-reader 1. This is, in case the user gives a query with the code P.01 to meter-reader 1, the meter-reader 1 asks the meter 2 for P.01 coded data load. In case, the user gives a query request with the code 128.12 as an input to meter-reader 1, it asks for 128.12. Thus, in conventional systems the user can only retrieve load data from the meter 2 by means of the meter-reader 1 if the user knows the brand-specific code used by the meter 2 for data communication with the meter-reader 1.

According to the inventive concept, illustrated in the present example, the user can input the load query in a unified common format for all brands of meters, the format might be termed LP for the load profile. Thus, the invention consists in particular in that the user gives LP as an input to meter-reader 1 and the meter-reader 1 will ask (with) the appropriate code to the meter 2. The meter-reader 1 will decide what to ask up to brand and protocol of the meter 2. For example, if it is the binary (e.g. DLMS/Cosem) protocol then it will ask for the structure (data structure) used by the meter 2, if it is ASCII then it will ask with the appropriate code for the brand (i.e. P.01 for Makel).

In other words, the meter-reader 1 processes the non brand-specific load profile query according to a brand of the meter 2 into a brand-specific load profile query and retrieves 5 data of a load profile from the meter 2 based on said brand-specific load profile query.

In more detail, the meter-reader 1 receives 3 an input of a load profile request using a format independent from the brand of the meter 1. For receiving 3 by the meter-reader 1 the non brand-specific load profile query, a unified request format is used at the interface on a higher level of an automatic meter reading system 6. In other words, the unified request format is independent of the underlying format, thus independent of the brand of the meter 2.

The meter-reader 1 determines the brand-specific code according to the brand of the meter 2 and asks the meter 2 for a load profile by using the brand-specific code. For determining the brand-specific code according to the brand of the meter 2, the meter-reader 1 determines the brand of the meter 2, the brand-specific protocol used by the meter 2 and the brand-specific code of the meter 2.

For determining the brand of the meter 2, in a preferred embodiment, the meter-reader 1 sends a trigger signal to the meter 2 and receives from the meter 2 a signal carrying information on the brand of the meter 2.

In a preferred embodiment, the meter-reader 1 determines the brand-specific code according to the brand of the meter 2 by sending a code request signal to the meter 2 and receiving from the meter 2 information on the brand-specific code used by the meter 2.

As soon as the meter-reader 1 knows the brand-specific code used by the meter 2, the meter-reader 1 transforms the query request from the user which is in a common format which is not specific to the brand of the meter 2, into a query request in the format according to the code used by the meter 2, thus into the brand-specific query code according to the brand of the meter 2.

The meter-reader 1 asks 4 the meter 2 by means of the brand-specific query code for load profile data. According to this brand-specific load query of the meter-reader 1, the meter 2 sends data on the requested load data to the meter-reader 1, such that the meter-reader 1 retrieves 5 from the meter 2 data on (or "of") the load profile requested by the brand-specific load query. It is to be repeated that the meter 2 can only process query requests in the format or code which the meter 2 uses determined by its brand. Therefore, the meter 2 is only able to answer to query requests in the format or code according to its brand as given in the above examples of relations of brands, codes and protocols.

In a preferred embodiment, the meter-reader 1 retrieves data of a load profile based on the processed load profile query, this means based on the brand-specific load profile query transformed out of the non brand-specific load profile query.

The following situations might be given alternatively or in combination. The meter-reader 1 might read load profile data from the meter 2 regularly. The meter-reader 1 might read values at a beginning of a measurement period. The meter-reader 1 might read values at and end of a measurement period. The values measured by the meter 2 and read by the meter-reader might determining an electrical load, in particular determining an electrical consumption, in particular measured in kW/h, values determining a consumption of water, values determining a consumption of gas, data indicating relative values by indicating a difference to previously determined data, data indicating absolute values by indicating a total load and/or a total consumption. The meter-reader 1 might retrieve data from the meter 2 which are data stored in a memory of the meter 2.

Figure 1 depicts a meter-reader 1 for collecting data of a load profile from a meter 2. The meter-reader 1 is configured for receiving 3 a non brand-specific load profile query, processing the non brand-specific load profile query according to a brand of the meter 2, in particular transforming the non brand-specific query into a brand-specific query according to the brand of the meter 1, asking 4 the meter 2 for load profile data by means of the brand-specific query, and retrieving 5 data of a load profile from the meter 2 based on said brand-specific load profile query, i.e. based on the processed load profile query, which in particular is transformed out of the non brand-specific load profile query, this means from the non brand-specific format or code into the brand-specific format or code, thus in the brand-specific load profile query.

Figures 1 shows also a processing unit 7 used for collecting data of a load profile from a meter 2. The processing unit 7 might be part of the meter-reader 1 or might be implemented as a distinctive device or might be part of automatic meter reading system 6. The processing unit 7 is adapted for receiving a non brand-specific load profile query, processing the non brand-specific load profile query according to a brand of the meter 2 and retrieving data of a load profile from the meter 2 based on said brand-specific load profile query.

The processing unit 7 may be implemented as a single unit, a stand-alone device, or within a database, integrated in a computer and/or within a computer network. The processing unit 7 may be implemented through the use of hardware, software and/or hardware capable of executing software in association with appropriate software.

More specifically, the processing unit 7 can be comprised or implemented by circuit-based processes, including possible implementation as a single integrated circuit, such as an ASIC (= Application Specific Integrated Circuit) or such as an FPGA (= Field Programmable Gate Array), a multi-chip module, a single card, or a multi-card circuit pack. The functions of processing unit 7 may be implemented as processing blocks in a software program. Such software may be employed in a digital signal processor, micro-controller, or general-purpose computer implemented as a single device or integrated in a computer network.

The processing unit 7 may comprise program code embodied in tangible media, such as magnetic recording media, optical recording media, solid state memory, floppy diskettes, CD-ROMs, hard drives, or any other machine-readable storage medium, wherein, when the program code is loaded into and executed in the control unit, the processing unit 7 becomes an apparatus used for practicing the invention.

It is an advantage of the present invention that higher levels of the automatic reading meter system 6, in particular the level which is used for input by a user, and thus the user himself does not need to know brand-specific load profile query formats. Thus, the user can input load profile query in any format, in particular in a single or common format for all kinds or brands of meters 2, from which the user want to retrieve load profile data. This is, without regard of the format used by the meter 2, from which the user wants to get load profile data, the user can use a common format for inputting the load profile query. The meter-reader 1 used by the user will transform the query of the user which is unspecified in regard of the meter's brand into a brand-specific query and will retrieve based on the query transformed into the brand-specific format, load profile data from the meter 2.

Thus, the present invention provides the advantage there is used and needed only one kind of input (for the user) to request load profiles from any brand of meters 2. The meter-reader 1 implemented uses the single request and asks with the appropriate brand-specific code on the data channel with the meter 2. This way, the user or users of the input software, in particular the automatic meter reading system 6, has/have a unified interface whereas not losing the ability of query different brands of meters 2 for load profile data. Thus the user is provided with the possibility of using a common request format for collecting load profile data from meters 2, this means a request format which is common for all kinds of brands of meters 2. In other words, the unified request format is independent of the underlying format, thus independent of the brand of the meter 2, of the brand-specific query sent then from the meter-reader 1 to the meter 2.

## Claims

1. A method for collecting, by a meter-reader (1), data of a load profile from a meter (2), the method comprising:
- receiving (3), by the meter-reader (1), a non brand-specific load profile query;
- processing, by the meter-reader (1), the non brand-specific load profile query according to a brand of the meter (2) into a brand-specific load profile query; and
- retrieving (5), by the meter-reader (1), data of a load profile from the meter (2) based on said brand-specific load profile query.

2. The method according to claim 1, wherein the step of receiving (3), by the meter-reader (1), a non brand-specific load profile query comprises:
- receiving an input of a load profile request using a format independent from the brand of the meter (1).

3. The method according to claim 1, wherein the step of receiving, by the meter-reader (1), a non brand-specific load profile query comprises:
- using a unified request format at an interface (6) on a higher level of an automatic meter reading system.

4. The method according to claim 1, wherein the step of processing the non brand-specific load profile query according to a brand of the meter comprises:
- determining a brand-specific code according to the brand of the meter (2); and
- asking (4), by the meter-reader (1), the meter (2) for a load profile by using the brand-specific code.

5. The method according to claim 4, wherein the step of determining a brand-specific code according to the brand of the meter (2) comprises:
- determining the brand of the meter (2);
- determining a brand-specific protocol used by the meter (2); and
- determining the brand-specific code of the meter (2).

6. The method according to claim 5, wherein the step of determining the brand of the meter (2) comprises determining the brand of the meter (2) based on an input information received via a user interface connected to the meter-reader (1).

7. The method according to claim 5, wherein the step of determining the brand of the meter (2) comprises determining the brand of the meter (2) by the meter-reader (1).

8. The method according to claim 7, wherein the step of determining the brand of the meter (2) by the meter-reader (1) comprises;
- sending, by the meter-reader (1) a trigger signal to the meter (2); and receiving, by the meter-reader (1), from the meter (2) a signal carrying information on the brand of the meter (2).

9. The method according to claim 4, wherein determining a brand-specific code according to the brand of the meter (2) comprises:
- sending, by the meter-reader (1), a code request signal to the meter (2); and
- receiving, by the meter-reader (1), from the meter (2) information on the brand-specific code used by the meter (2).

10. The method according to claim 4, wherein the brand-specific code comprises at least one of an ASCII code or a binary code.

11. The method according to claim 1, wherein the step of retrieving data of a load profile based on said brand-specific load profile query comprises:
- receiving data from the meter (2), wherein the data comprise one or more of the groups comprising: values read by the meter-reader (1) regularly, values read by the meter-reader (1) at a beginning of a measurement period, values read by the meter-reader (1) at and end of a measurement period, values determining an electrical load, in particular determining an electrical consumption, in particular measured in kW/h, values determining a consumption of water, values determining a consumption of gas, data indicating relative values by indicating a difference to previously determined data, data indicating absolute values by indicating a total load and/or a total consumption.

12. The method according to claim 11, wherein retrieving data from the meter (2) comprises receiving data stored in a memory of the meter (2).

13. A meter-reader (1) for collecting data of a load profile from a meter (2), the meter-reader (1) is configured for:
- receiving a non brand-specific load profile query;
- processing the non brand-specific load profile query according to a brand of the meter (2); and
- retrieving data of a load profile from the meter (2) based on said brand-specific load profile query.

14. A processing unit (7) used for collecting data of a load profile from a meter (2), the processing unit (7) adapted for receiving a non brand-specific load profile query, processing the non brand-specific load profile query according to a brand of the meter (2) and retrieving data of a load profile from the meter (2) based on said brand-specific load profile query.

15. A software product adapted to execute the method according to claims 1 to 12, when executed on a computer.
